# EUROPEAN PATENT APPLICATION

(11) **EP 2 234 157 A2**
(43) Date of publication of application: **29.09.2010**
(21) Application number: 10250242.4
(22) Date of filing: 12.02.2010
(51) Int. Cl.: H01L 23/66

(54) **Semiconductor device**

(30) Priority: 23.03.2009 JP 2009070852
(71) Applicant: Kabushiki Kaisha Toshiba, Minato-ku, Tokyo 105-8001 (JP)
(72) Inventor: Kashiwabara, Yasushi, Tokyo 105-8001 (JP)
(74) Representative: Maury, Richard Philip

(57) **Abstract**

A semiconductor device including: a base substrate; a frame body mounted on the base substrate and formed with a recessed portion in each of both side faces thereof opposing to each other; a semiconductor chip mounted on the base substrate within an area of the frame body; a dielectric block inserted into the recessed portion in the frame body; a waveguide formed on a surface of the dielectric block and electrically connected with the semiconductor chip; a plurality of protection patterns respectively formed along the waveguide at positions spaced from the waveguide on both sides of the waveguide on the surface of the dielectric block; and a metal layer formed on at least each of the both side faces of the dielectric block opposing to each other by plating.

## Description

### CROSS-REFERENCE TO RELATED APPLICATIONS

This application is based upon and claims the benefit of priority from the prior Japanese Patent Application No.2009-070852 filed in Japan on March 23, 2009; the entire contents of which are incorporated herein by reference.

### BACKGROUND OF THE INVENTION

### 1. Field of the Invention

The present invention relates to a semiconductor device with semiconductor chips sealed in an interior of a frame body.

### 2. Description of the Related Art

A conventional semiconductor device has a base substrate on which semiconductor chips and input/output matching circuits are placed, respectively. On the base substrate, there is provided a metal frame body having a recessed portion on each of both side faces opposing to each other. The semiconductor chips and the input/output matching circuits are placed in the interior of the frame body. A lid is placed on the frame body to seal the interior of the frame body.

In the semiconductor device, the semiconductor chips are respectively connected with the input/output matching circuits formed on input and output sides of the chips through a plurality of wires.

The input matching circuit is connected with input line formed on input side of the input matching circuit through a plurality of wires. The output matching circuit is connected with output line formed on output side of the output matching circuit through a plurality of wires.

The input line is connected with an input lead for inputting a signal from the exterior of the semiconductor device to the interior of the device, while the output line is connected with an output lead for outputting a signal from the interior of the semiconductor device to the exterior of the device, as disclosed in Japanese Patent Application Laid-Open Nos. 2003-115732 and 2007-81125.

Each of the input/output lines is formed on a surface of a lower dielectric block disposed on the exterior of each of the input/output matching circuits. In addition, on the lower dielectric blocks, each of an upper dielectric blocks is formed.

Around the dielectric block comprised of the lower dielectric block and the upper dielectric block, there is a metal layer formed from metal such as gold. By inserting the dielectric block into the recessed portion of the frame body through the metal layer, the interior of the frame body is sealed.

The metal layer formed around the dielectric block is formed according to an appropriate method such as soaking a surface of the dielectric block into liquid metal in a plating tank. Usually, the metal layer is formed, extending from a surface of the dielectric block. The width of the metal layer extending from the surface of the dielectric block varies from place to place, and the width of the extending metal layer cannot be controlled. Accordingly, the following problems occur:

Specifically, if extending widths of the metal layer vary from place to place, a distance between a metal extending portion and the input/output lines vary from place to place and a portion having different impedances occurs in the input/output lines, and thus the impedance of the input/output lines varies. The variations of the impedance are not constant because the width of the extending metal layer cannot be controlled. Accordingly, it is difficult to control the impedances of the input/output lines. Thus, a semiconductor device which has an impedance not fully matching between the input/output lines and the input/output matching circuits may be formed. As a result, for example, there is a problem that variations occur in output characteristics of a semiconductor device because there occur variations in the reflection quantity of signals in the input/output lines or between the input/output lines and the input/output matching circuits.

### SUMMARY

It is therefore one of the objects of the present invention to suppress the variances of the output performance of the semiconductor device.

According to an embodiment of the present invention, there is provided a semiconductor device including: a base substrate; a frame body mounted on the base substrate and formed with a recessed portion in each of both side faces thereof opposing to each other; a semiconductor chip mounted on the base substrate within an area of the frame body; a dielectric block inserted into the recessed portion in the frame body; a waveguide formed on a surface of the dielectric block and electrically connected with the semiconductor chip; a plurality of protection patterns respectively formed along the waveguide at positions spaced from the waveguide on both sides of the waveguide on the surface of the dielectric block; and a metal layer formed on at least each of the both side faces of the dielectric block opposing to each other by plating.

### BRIEF DESCRIPTION OF THE DRAWINGS

FIG. 1 is a top view of a semiconductor device according to an embodiment of the present invention;
FIG. 2 is a sectional view of the semiconductor device taken along alternate long and short dashed line A-A' of FIG. 1;
FIG. 3 is a sectional view of the semiconductor device taken along alternate long and short dashed line B-B' of FIG. 1;
FIG. 4 is an enlarged top view of a surface of a first dielectric block;
FIG. 5 is a sectional view of the first dielectric block taken along alternate long and short dashed line C-C' of FIG. 4;
FIG. 6 is an enlarged top view of a surface of a first dielectric block formed with a first protection pattern according to a first modified example;
FIG. 7 is a sectional view of the first dielectric block taken along alternate long and short dashed line D-D' of FIG. 6;
FIG. 8 is a sectional view of a first dielectric block formed with a first protection pattern according to a second modified example, taken along alternate long and short dashed line C-C' of FIG. 4;
FIG. 9 is an enlarged top view of a surface of a first dielectric block formed with a first protection pattern according to a third modified example;
FIG. 10 is an enlarged top view of a surface of a first dielectric block formed with a first protection pattern according to a fourth modified example; and
FIG. 11 is an enlarged top view of another embodiment of a connection portion of input/output lines with an input/output matching circuit in a semiconductor device according to an embodiment of the present invention.

### DETAILED DESCRIPTION OF THE EMBODIMENTS

A semiconductor device according to an embodiment of the present invention will be described in detail below with reference to the accompanying drawings.

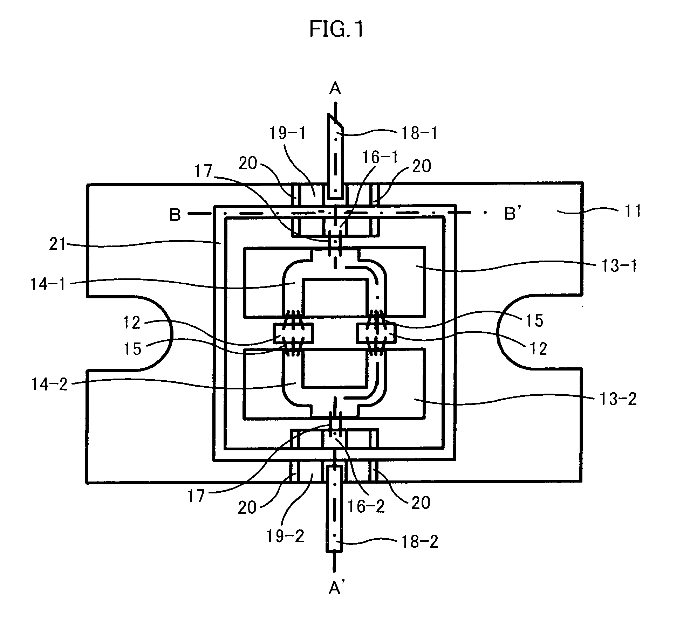

FIG. 1 is a top view of a semiconductor device according to an embodiment of the present invention. The illustration in FIG. 1 is shown in a partially omitted manner.

As illustrated in FIG. 1, a plurality of semiconductor chips are placed on a metal base substrate 11. The semiconductor chip is, for example, a field effect transistor (FET) 12 formed from a GaAs-based material, hereinafter referred to as "GaAsFET 12", which is used for power amplification. On an input/output part of the GaAsFET 12, a first dielectric substrate 13-1 and a second dielectric substrate 13-2 are placed. The first dielectric substrate 13-1 and the second dielectric substrate 13-2 are respectively formed from ceramics, for example.

On a surface of the first dielectric substrate 13-1, a first circuit pattern is formed. The first circuit pattern is an input matching circuit 14-1, for example. On a surface of the second dielectric substrate 13-2, a second circuit pattern is formed. The second circuit pattern is an output matching circuit 14-2, for example.

Connection of the input matching circuit 14-1 with the GaAsFET 12 and connection of the output matching circuit 14-2 with the GaAsFET 12 are made through a first connection part 15, respectively. The first connection part 15 is comprised of a plurality of conductor lines, for example. The conductor line is formed from gold or aluminum, for example.

The input matching circuit 14-1 is connected with one end of a first waveguide through a second connection part 17. Similarly, the output matching circuit 14-2 is connected with one end of a second waveguide through the second connection part 17. The first waveguide is an input line 16-1, for example, while the second waveguide is an output line 16-2, for example. The second connection part 17 is comprised of a plurality of conductor lines, for example. The conductor line is formed from gold or aluminum, for example.

The other end of the input line 16-1 is connected with an input lead 18-1, which is connected with an external circuit (not illustrated). The other end of the output line 16-2 is connected with an output lead 18-2, which is connected with an external circuit (not illustrated). The input line 16-1 and the output line 16-2 are strip lines or microstrip lines, for example, at least having a gold surface.

The input line 16-1 is formed on a surface of a first dielectric block 19-1. The first dielectric block 19-1 is disposed on an input side of the first dielectric substrate 13-1. Similarly, the output line 16-2 is formed on a surface of a second dielectric block 19-2. The second dielectric block 19-2 is disposed on the output side of the second dielectric substrate 13-2. The first dielectric block 19-1 and the second dielectric block 19-2 are formed from ceramics, for example.

On the first dielectric block 19-1, a third dielectric block 19-3 (not illustrated in FIG. 1) is formed. On the other hand, on the second dielectric block 19-2, a fourth dielectric block 19-4 (not illustrated in FIG. 1) is formed. The third and the fourth dielectric blocks 19-3, 19-4 are dielectrics, such as ceramics.

Around the first and the third dielectric blocks 19-1, 19-3 and around the second and fourth dielectric blocks 19-2, 19-4, respectively, metal layers 20 are formed by means of plating. The metal layer 20 is formed from metal, such as Au.

On the base substrate 11, a metal frame body 21 is further formed. The GaAsFET 12 and the first and second dielectric substrates 13-1, 13-2 are respectively formed in the interior of the frame body 21.

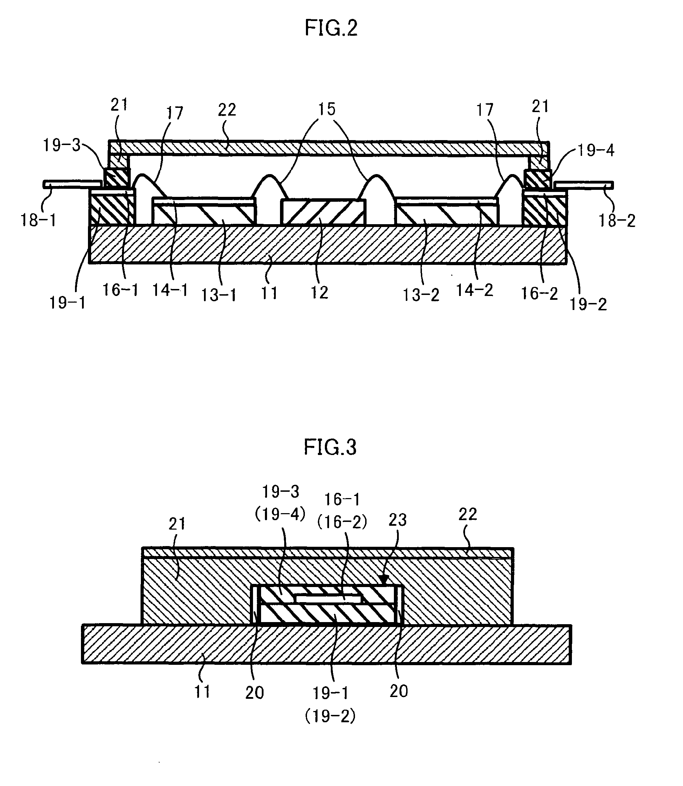

FIG. 2 is a sectional view taken along alternate long and short dashed line A-A' of FIG. 1. As illustrated in FIG. 2, on the frame body 21, a metal lid 22 is disposed. The lid 22 seals the interior of the frame body 21.

FIG. 3 is a sectional view taken along alternate long and short dashed line B-B' of FIG. 1. As illustrated in FIG. 3, the metal frame body 21 has a recessed portion 23 at each position of both side faces opposing to each other. In the recessed portions 23, there are respectively inserted the first and the third dielectric blocks 19-1, 19-3 around which the metal layer 20 is formed and the second and the fourth dielectric blocks 19-2, 19-4 around which the metal layer 20 is formed. By inserting the dielectric blocks 19-1 to 19-4 each having the metal layer 20 formed from a relatively soft material, such as gold, into the recessed portion 23 in this way, no gap is formed between the dielectric blocks 19-1 to 19-4 and the recessed portion 23, so that the interior of the frame body 21 is sealed.

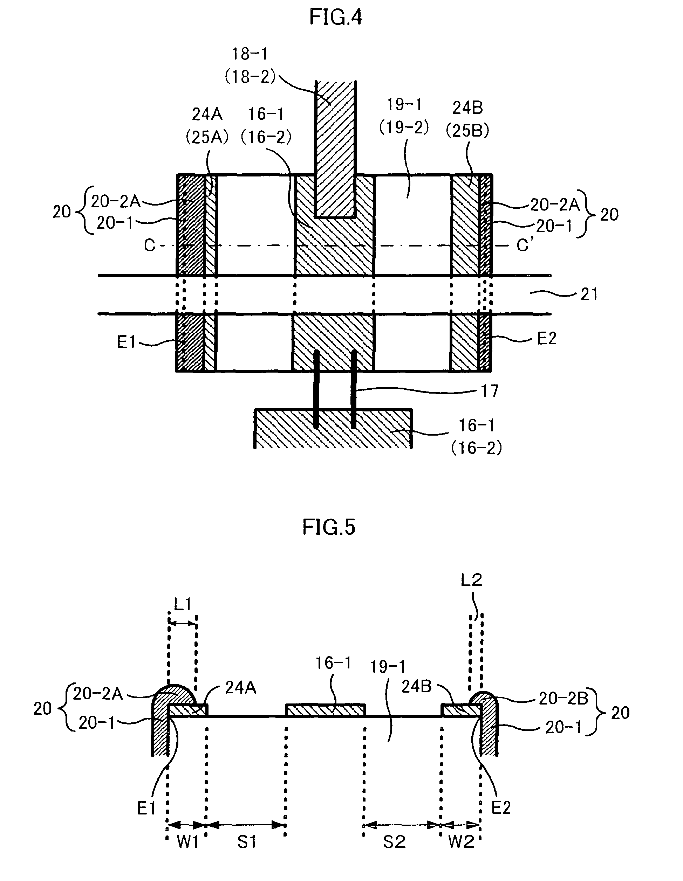

FIG. 4 is an enlarged top view of a surface of the first dielectric block 19-1. As illustrated in FIG. 4, on a surface of the first dielectric block 19-1, the input line 16-1 and first protection patterns 24A, 24B are formed. The first protection patterns 24A, 24B are formed in a manner that the input line 16-1 is placed therebetween at a fixed interval.

On a surface of the second dielectric block 19-2 as well, the output line 16-2 and second protection patterns 25A, 25B are formed in the same way as in FIG. 4. The first and second protection patterns 24A, 24B, 25A, 25B are formed from the same conductor as that of the input line 16-1 and the output line 16-2, for example.

In addition, the metal layer 20 around the first and second dielectric blocks 19-1, 19-2 is formed by means of plating. Accordingly, the metal layer 20 is formed to extend onto surfaces of the first and second protection patterns 24A, 24B, 25A, 25B. Of the metal layer 20, a portion around the first and second dielectric blocks 19-1, 19-2 is referred to as a first metal layer 20-1 and portions extending onto the first and second protection patterns 24A, 24B, 25A, 25B are referred to as second metal layers 20-2A, 20-2B. Of the second metal layers 20-2A, 20-2B, a portion extending onto the first or second protection patterns 24A, 25A is referred to as the second metal layer 20-2A and a portion extending onto the first or second protection patterns 24B, 25B is referred to as the second metal layer 20-2B.

The metal layer 20, the frame body 21 and the base substrate 11 are in contact with each other. Further, the metal layer 20 and the first and second protection patterns 24A, 24B, 25A, 25B are in contact with each other. Accordingly, when the base substrate 11 is grounded, for example, the first and second protection patterns 24A, 24B, 25A, 25B are also placed into a grounded state.

FIG. 5 is a sectional view taken along alternate long and short dashed line C-C' of FIG. 4. Referring now to FIGS. 4 and 5, the first protection patterns 24A, 24B will be described below in further detail. Since the second protection patterns 25A, 25B can be formed in the same way as the first protection patterns 24A, 24B, the description thereof will not be repeated.

As illustrated in FIG. 4, the first protection patterns 24A, 24B are formed along the input line 16-1. Of four sides constituting a surface of the first dielectric block 19-1, the sides in no contact with the input line 16-1 are defined as a side E1 and a side E2. In this case, the first protection patterns 24A, 24B are formed so as to be in contact with the side E1 or the side E2. Further, the protection patterns 24A, 24B are formed to have a length equal to those of the side E1 and the side E2.

As illustrated in FIG. 5, a pattern width W1 of the first protection pattern 24A and a pattern width W2 of the first protection pattern 24B are formed to be larger than a width L1 of the second metal layer 20-2A and a width L2 of the second metal layer 20-2B, respectively. This is because, when the width L1 of the second metal layer 20-2A and the width L2 of the second metal layer 20-2B are larger than the pattern widths W1, W2 of the first protection patterns 24A, 24B, an impedance of the input line 16-1 varies with the widths L1, L2 of the second metal layers 20-2A, 20-2B. Once the impedance of the input line 16-1 varies in this way, it becomes difficult to solve a problem found in the conventional semiconductor device.

As illustrated in FIG. 5, the pattern width W1 of the first protection pattern 24A and the pattern width W2 of the first protection pattern 24B are set to be equal to each other. However, the width L1 of the second metal layer 20-2A and the width L2 of the second metal layer 20-2B are not set to be equal to each other because these are beyond control.

Further, a distance S1 between the input line 16-1 and the first protection pattern 24A and a distance S2 between the input line 16-1 and the first protection pattern 24B are set to be equal to each other.

According to the semiconductor device in the embodiment described above, the distances S1, S2 between the input line 16-1 and the first protection patterns 24A, 24B and distances between the output line 16-2 and the second protection patterns 25A, 25B can be kept constant, respectively. Hence, the impedances of the input line 16-1 and the output line 16-2 can be controlled to be constant with ease. Further, because the impedances of the input/output lines 16-1, 16-2 are constant, respectively, the impedances can be matched with ease between the input/output lines 16-1, 16-2 and the input/output matching circuits 14-1, 14-2. The amount of reflection occurring in the input/output lines 16-1, 16-2 or between the input lines 16-1, 16-2 and the input/output matching circuits 14-1, 14-2 can be kept constant. Thus, variances in the output performance of the semiconductor device can be suppressed.

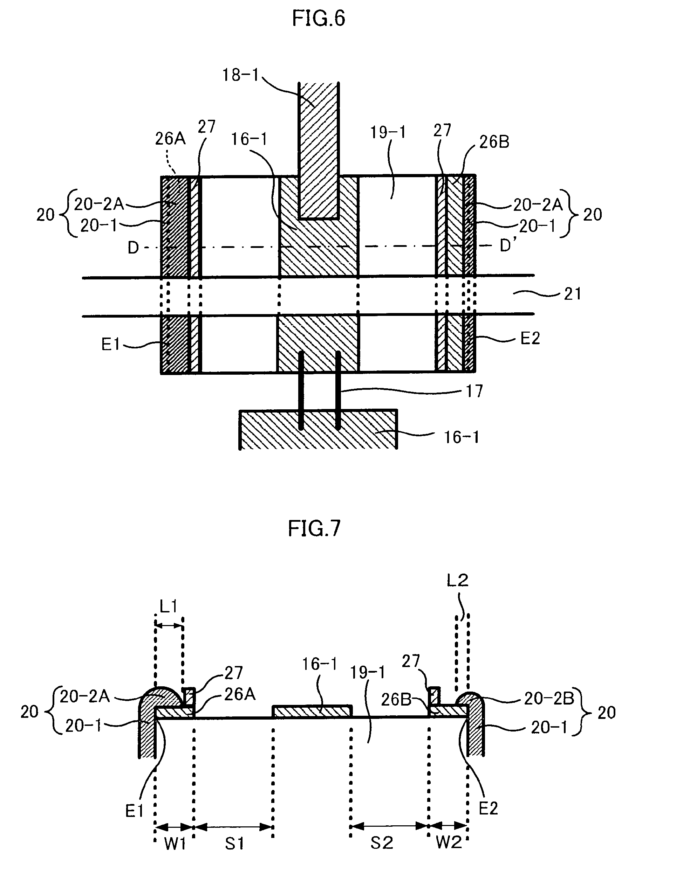

Referring next to FIGS. 6 to 10, modified examples of the first protection patterns 24A, 24B will be described below. The second protection patterns 25A, 25B can be modified in the same way as the first protection patterns 24A, 24B and therefore the description thereof will not be repeated.

### [First Modified Example]

FIG. 6 is a top view of a first dielectric block 19-1 formed with a protection pattern according to a first modified example. FIG. 7 is a sectional view taken along alternate long and short dashed line D-D' of FIG. 6. As illustrated in FIGS. 6 and 7, protection walls 27 are formed on the first protection patterns 26A, 26B. The material of the protection wall 27 may be a conductor or a dielectric.

The protection wall 27 may be formed anywhere on the first protection patterns 26A, 26B. However, preferably, the protection wall 27 is formed at a position nearest to the input line 16-1 ,on the first protection patterns 26A, 26B. Further, preferably, the protection wall 27 is formed to extend along sides E1 and E2 with a length equal to those of the sides E1, E2.

The width of the protection wall 27 is not limited.
In addition, the height of the protection wall 27 only has to be large enough to prevent the second metal layer 20-2A, 20-2B from extending beyond the protection wall 27.

By forming the protection wall 27 on the first protection patterns 26A, 26B as described above, the second metal layers 20-2A, 20-2B can be prevented more effectively from extending out from the first protection patterns 26A, 26B.

### [Second Modified Example]

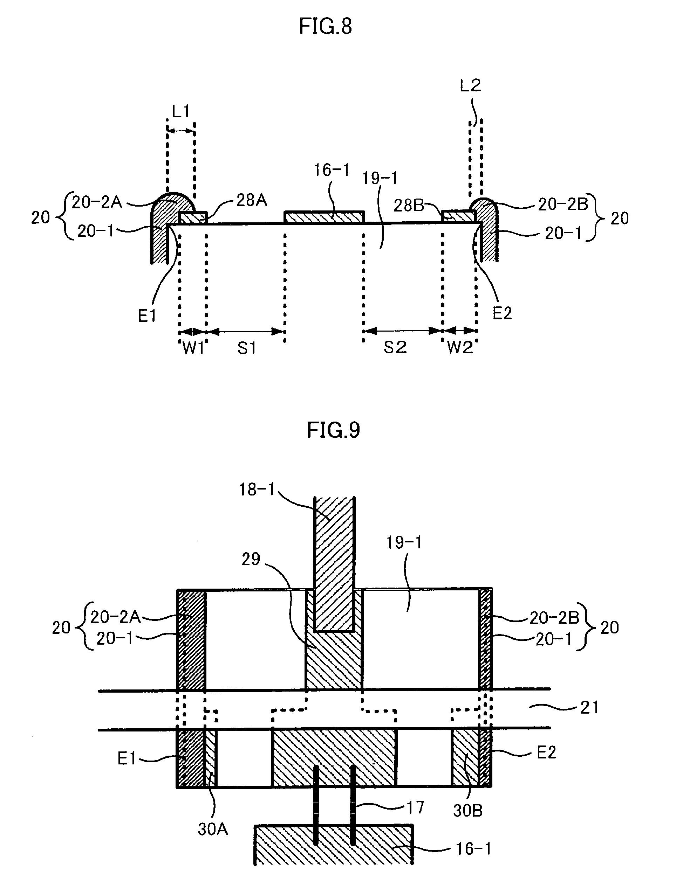

FIG. 8 is a sectional view of a first dielectric block 19-1 formed with a protection pattern according to a second modified example, taken along alternate long and short dashed line C-C' of FIG. 4. As illustrated in FIG. 8, first protection patterns 28A, 28B are formed, being spaced from a side E1 and a side E2. The spaced width is not limited as long as the second metal layers 20-2A, 20-2B are connected with the first protection patterns 28A, 28B.

### [Third Modified Example]

FIG. 9 is a top view of a first dielectric block 19-1 formed with a protection pattern according to a third modified example. As illustrated in FIG. 9, when a width of an input line 29 varies from place to place, first protection patterns 30A, 30B may be formed along only a wide portion of the input line 29. Specifically, the first protection patterns 30A, 30B may be formed at different lengths from those of the sides E1, E2. This is effective when a distance between a portion having a narrow width of the input line 29 and the second metal layers 20-2A, 20-2B is wide enough to prevent an impedance of the input line 29 from being substantially varied.

### [Fourth Modified Example]

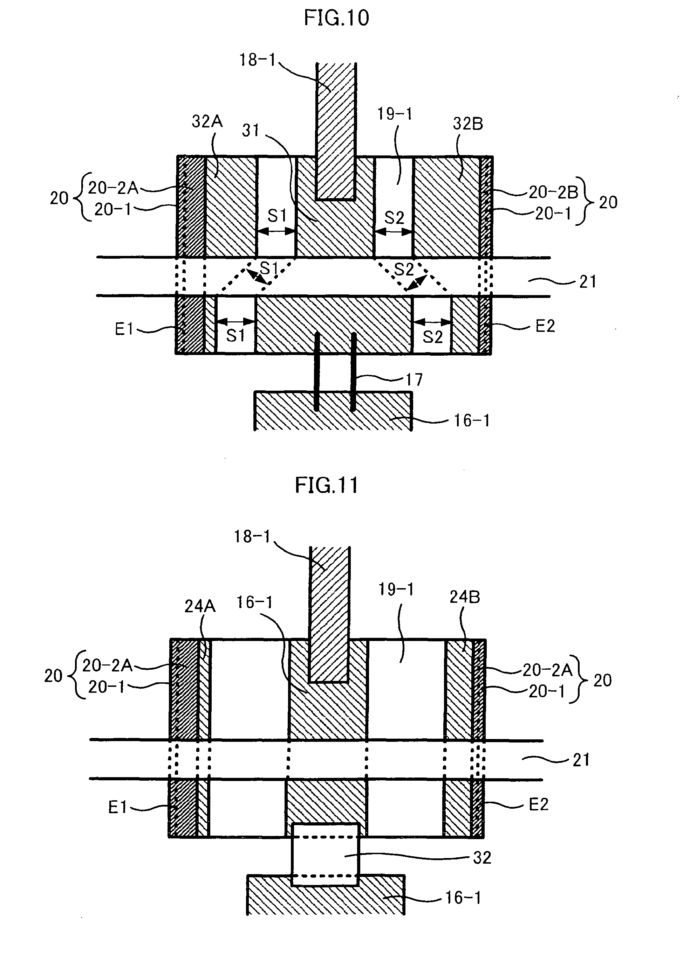

FIG. 10 is a top view of a first dielectric block 19-1 formed with a protection pattern according to a fourth modified example. As illustrated in FIG. 10, when a width of an input line 31 varies from place to place, first protection patterns 32A, 32B may be formed along a shape of the input line 31. Specifically, the first protection patterns 32A, 32B may be formed so that distances S1, S2 between the protection patterns 32A, 32B and the input line 31 are always substantially equal to each other. This is effective when distances between a portion having a narrow width of the input line 31 and the second metal layers 20-2A, 20-2B are narrow enough to substantially vary an impedance of the input line 31.

In addition to the respective modified examples described above, there are other modified examples such as those described below. For example, the first protection patterns 24A, 24B may be formed from materials different from each other. Moreover, it is not always necessary that the pattern width W1 of the first protection pattern 24A is equal to the pattern width W2 of the protection pattern 24B.

Further, the distance S1 between the input line 16-1 and the first protection pattern 20-2A may be different from the distance S2 between the input line 16-1 and the first protection pattern 20-2B.

When the input line 16-1 is not in the center of the first dielectric block 19-1, the distance S1 between the input line 16-1 and the first protection pattern 24A may be made equal to the distance S2 between the input line 16-1 and the first protection pattern 24B by changing the pattern width W1 of the first protection pattern 24A and the pattern width W2 of the first protection pattern 24B.

The second protection patterns 25A, 25B may be modified in the same way as in other modified examples of the first protection patterns 24A, 24B.

The semiconductor device according to embodiments of the present invention is as described above. However, the semiconductor devices according to the embodiments of the present invention are not limited to the respective embodiments.

FIG. 11 is an enlarged top view of another embodiment of a connection portion of the input line 16-1 with the input matching circuit 14-1 in a semiconductor device according to an embodiment of the present invention. For example, as illustrated in FIG. 11, a second connection part 32 for connecting the input line 16-1 with the input matching circuit 14-1 may be connected through foil-shaped metal formed from gold foil, aluminum foil or the like. In this way, the second connection part 17 illustrated in FIG. 1 may be any form that can electrically-connect the input/output lines 16-1, 16-2 with the input/output matching circuits 14-1, 14-2. Accordingly, the form of the second connection part 17 is not limited to a plurality of wires or metal foil. As is the case with the form of the second connection part 17 that is not limited, the form of the first connection part 15 is not limited either.

The semiconductor chip included in the semiconductor device described above may be any type of semiconductor chip without being limited to a GaAsFET 12. Thus, the semiconductor chip may be a GaNFET, for example.

The first dielectric substrate 13-1, the second dielectric substrate 13-2 and the first to fourth dielectric blocks 19-1 to 19-4 described above are not limited to the ones formed from ceramics, respectively.

The circuit patterns on the first dielectric substrate 13-1 and the second dielectric substrate 13-2 are not limited to the input matching circuit 14-1 and the output matching circuit 14-2. The circuit patterns including the input matching circuit 14-1 and the output matching circuit 14-2 are not always required. Particularly, if a semiconductor chip such as the GaAsFET 12 is connected with the input/output lines 16-1, 16-2 to have impedance matching, the input matching circuit 14-1 and the output matching circuit 14-2 are not always required. Accordingly, the first dielectric substrate 13-1 and the second dielectric substrate 13-2 are not always required either.

From the above, it will be understood that the semiconductor device of the invention has a waveguide which is preferably a microstrip line.

Also preferably the metal layer of the invention is formed from gold.

Also preferably, on the base substrate within the frame body, there are mounted a dielectric substrate and a circuit pattern formed on the dielectric substrate and connected with the semiconductor chip through a first connection portion, the waveguide is connected with the circuit pattern through a second connection portion, and the waveguide is electrically connected with the semiconductor chip through the first connection portion, the circuit pattern and the second connection portion; wherein the first connection portion is comprised of a plurality of wires, each of which wires may be formed from gold. The second connection portion may be comprised of a plurality of wires, each of which wires may be formed from gold. The first connection portion may be formed from metal foil, and the metal foil may be formed from gold. The second connection portion may however be formed from metal foil, and the metal foil may be formed from gold.

## Claims

1. A semiconductor device comprising:
a base substrate;
a frame body mounted on the base substrate and formed with a recessed portion in each of its opposed side faces;
a semiconductor chip mounted on the base substrate within an area of the frame body;
a dielectric block inserted into the recessed portion in the frame body;
a waveguide formed on a surface of the dielectric block and electrically connected with the semiconductor chip;
a plurality of protection patterns respectively formed along the waveguide at positions spaced from the waveguide on both sides of the waveguide on the surface of the dielectric block; and
a metal layer formed on at least each of the opposed side faces of the dielectric block by plating.

2. The semiconductor device according to claim 1, wherein the metal layer includes a first metal layer formed on at least each of the opposed side faces of the dielectric block by plating and a second metal layer produced on the protection pattern as a result of formation of the first metal layer.

3. The semiconductor device according to claim 1, wherein a protection wall is formed on each of the surfaces of the plurality of protection patterns.

4. The semiconductor device according to claim 3, wherein the protection wall is formed at a position nearest to the waveguide, on the surfaces of the plurality of protection patterns.

5. The semiconductor device according to claim 1, wherein each of the plurality of protection patterns is formed to be in contact with two sides not bordering on the waveguide, of four sides constituting the surface of the dielectric block.

6. The semiconductor device according to claim 5, wherein each of the plurality of protection patterns is formed to be in contact with a part of the two sides.

7. The semiconductor device according to claim 1, wherein each of the plurality of protection patterns is formed at a position spaced from the two sides.

8. The semiconductor device according to claim 1, wherein each of the plurality of protection patterns is formed to always have a substantially equal distance relative to the waveguide.

9. The semiconductor device according to claim 1, wherein each of the plurality of protection patterns is formed to have a substantially equal width.

10. The semiconductor device according to claim 1, wherein each of the plurality of protection patterns is formed from the same material as that of the waveguide.

11. The semiconductor device according to claim 1, wherein the dielectric block is composed of a first dielectric block formed with the waveguide and the plurality of protection patterns and a second dielectric block formed on the first dielectric block.

12. The semiconductor device according to claim 1, wherein a lid is placed on the frame body.

13. The semiconductor device according to claim 1, wherein the semiconductor chip is a GaAs-based field effect transistor.

14. The semiconductor device according to claim 1, wherein,
on the base substrate within the frame body, there are mounted a dielectric substrate and a circuit pattern formed on the dielectric substrate and connected with the semiconductor chip through a first connection portion,
the waveguide is connected with the circuit pattern through a second connection portion, and
the waveguide is electrically connected with the semiconductor chip through the first connection portion, the circuit pattern and the second connection portion.

15. The semiconductor device according to claim 14, wherein the circuit pattern is a matching circuit.
